# EUROPÄISCHE PATENTSCHRIFT

(11) **EP 2 198 484 B1**
(45) Veröffentlichungstag und Bekanntmachung des Hinweises auf die Patenterteilung: **05.12.2018**
(21) Anmeldenummer: 08786264.5
(22) Anmeldetag: 18.07.2008
(51) Int. Cl.: H01R 12/71

(54) **ELEKTRISCHE SCHALTANORDNUNG MIT EINEM MID-SCHALTUNGSTRÄGER UND EINER DAMIT VERBUNDENEN VERBINDUNGSSCHNITTSTELLE**
ELECTRIC CIRCUIT ARRANGEMENT HAVING AN MID CIRCUIT MOUNT AND A CONNECTION INTERFACE CONNECTED THERETO
DISPOSITIF DE COMMUTATION ÉLECTRIQUE COMPRENANT UN SUPPORT DE CIRCUIT MID ET UNE INTERFACE DE CONNEXION ASSOCIÉE

(30) Priorität: 04.09.2007 DE 102007041892
(43) Veröffentlichungstag der Anmeldung: 23.06.2010
(73) Patentinhaber: Robert Bosch GmbH, 70442 Stuttgart (DE)
(72) Erfinder: KOPF, Stefan, 87545 Burgberg (DE); ROHDE, Hartmut, 87448 Waltenhofen (DE)
(86) Internationale Anmeldenummer: PCT/EP2008/059484
(87) Internationale Veröffentlichungsnummer: WO 2009/030553

(56) Entgegenhaltungen:
- EP-A2- 2 167 930
- WO-A-03/079499
- DE-A1-102005 015 109
- DE-U1-202004 020 759
- FR-A- 2 857 782

## Beschreibung

### Stand der Technik

Die Erfindung betrifft eine elektrische Schaltungsanordnung mit einem MID-Schaltungstrager und einer Leiterplatte.

Das Dokument DE 10 2005 015 109 A1 beschreibt eine elektrische Schaltanordnung mit einem MID Schaltungsträger und einer elektrischen Verbindungsschnittstelle, wobei die Verbindungsschnittstelle auf einer Oberfläche des MID Schaltungsträgers angeordnet ist, und die elektrische Schaltanordnung ferner mindestens ein elektrisches Kontaktpaar mit mindestens einem Verbindungsschnittstellen Kontaktelement und mindestens einem auf der Oberfläche des MID Schaltungsträgers vorgesehenen und dem Verbindungsschnittstellen Kontaktelement gegenüber angeordneten MID Kontaktelement umfasst.

Das Dokument DE 10 2004 020 759 U1 beschreibt eine elektrische Maschine, umfassend ein Polgehäuse zur Aufnahme elektromechanischer Bauteile, ein Getriebegehäuse und eine Leiterplatte, wobei das Getriebegehäuse aus einem Kunststoffmaterial hergestellt ist und Leiterbahnen in das Getriebegehäuse integriert sind, um eine elektrische Verbindung mit der Leiterplatte, wozu die Leiterplatte in eine nutförmige Ausnehmung im Getriebegehäuse eingeschoben wird, wobei die Leiterbahn mittels MID-Technik in das Getriebegehäuse integriert sind.

Das Dokument FR 2 857 782 A1 betrifft einen anisotropen Film, der eine haftfähige Isolationsschicht mit elektrisch leitfähigen Einschlüssen betrifft.

Die Verwendung von Leiterplatten, PCBs, ist ein Standardverfahren zur Verbindung von elektrischen Bauelementen. Die Verbindungen werden durch Leiterbahnen definiert, die auf einer Oberfläche einer ebenen Leiterplatte verlaufen. Leiterplatten bieten guten Schutz vor elektrostatischen Entladungen und haben gute Eigenschaften hinsichtlich der elektromagnetischen Verträglichkeit. Leiterbahnen können zwar ein sehr dichtes Verbindungsnetz vorsehen, sind jedoch im Wesentlichen auf einer Ebene beschränkt, sodass Verbindungen, die nicht parallel zur Leiterplatte verlaufen, mittels zusätzlichen Bauelementen oder Mechaniken vorgesehen werden müssen.
Dreidimensionale Leiterbahnstrukturen können mittels spritzgegossener Schaltungsträger, MIDs, erzeugt werden, wodurch beispielsweise Gehäuse und Schaltungsträger vereint werden. Auf Grund des Herstellungsverfahrens können MID-Substrate nur einfache Schaltungsstrukturen mit wenig Bauelementen und geringer Flächenkonzentration erzeugen. Eine Durchkontaktierung ist nur eingeschränkt möglich. Mittels spritzgegossener Schaltungsträger sind weitere Miniaturisierungen möglich, insbesondere bei Schaltungen mit dreidimensionalen Elementen, beispielsweise Messaufhehmer, oder elektrische Kontaktvorrichtungen.
Gemäß dem Stand der Technik werden, insbesondere auf Grund der unterschiedlichen Eigenschaften, Herstellungsprozesse und Einsatzmöglichkeiten getrennt voneinander als Schaltungsträger eingesetzt. Da MID eine sehr junge Technologie ist, sind keine üblichen Verbindungsmechaniken mit geringer Komplexität bekannt.

### Offenbarung der Erfindung

Mittels der erfindungsgemäßen Schaltanordnung ist es möglich, spritzgegossene Schaltungsträger und Leiterplatten mit einer einfachen Technik und üblichen, bekannten Verfahren ohne aufwändige externe Verbindungselemente miteinander zu kombinieren. Durch die Kombination kann erreicht werden, dass eine elektrische Schaltungsanordnung sowohl die Vorteile der spritzgegossene Schaltungsträger, MID (molded interconnect devices), als auch der Leiterplatten, PCB (printed ciruit board) vereint werden können, sodass dreidimensionale Schaltungsanordnungen, wie sie mit MID möglich sind, mit einer hohen Verschaltungsdichte und hoher Bauteildichte, wie sie mittels PCB-Technik vorgesehen werden können mit einfachen bereits bekannten Herstellungsprozessen erzeugt werden können.

Ferner sind zur Kontaktierung von Leiterplatten der erfindungsgemäßen elektrischen Schaltanordnung keine zusätzlichen sequenziellen Prozesse wie Drahtbonden oder Anlöten von Kontakten notwendig, zudem sind keine zusätzlichen mechanischen Steckverbindungen erforderlich, die sowohl zusätzliches Volumen als auch zusätzliche Herstellungskomplexität erfordern. Mit mehrlagigen Leiterplatten wird die Layoutfläche optimal genutzt und eine sehr hohe Bauteildichte und Verknüpfungsdichte erreicht. Ferner können auch die oben genannten Vorteile der Leiterplattentechnik auf die elektrische Schaltanordnung übertragen werden, ohne Nachteile in Kauf nehmen zu müssen. Insbesondere ermöglicht das Verfahren eine einfache und kostengünstige Möglichkeit, eine Vielzahl von Kontakten zwischen einem MID-Schaltungsträger und einer Verbindungsschnittstelle einer Leiterplatte vorzusehen. Grundsätzlich betrifft die erfindungsgemäße elektrische Schaltanordnung Verbindungen von mindestens einem MID-Substrat mit mindestens eine Leiterplatte, wobei eine Vielzahl von MID-Substraten eine oder mehrere Leiterplatten umfasst, oder ein MID-Substrat eine oder mehrere Leiterplatten umfasst, kontaktieren kann.

Das der Erfindung zu Grunde liegende Konzept besteht darin, MID-Schaltungsträger direkt mit einer Leiterplatte, die entlang einer Fläche oder Ebene verläuft, über MID-Kontaktelemente elektrisch zu verbinden, die an eine Oberfläche des MID-Schaltungsträgers vorgesehen sind. Da es sich bei Verbindungsschnittstellen von Leiterplatten ebenfalls um oberflächenbezogene Kontaktelemente handelt, ermöglichen derartige auf Oberflächen vorgesehene MID-Kontaktelemente eine unkomplizierte direkte elektrische Kombination zwischen den verschiedenen Techniken. Da sich Leiterplatten vorzugsweise in einer Ebene erstrecken, sind die MID-Kontaktelemente insbesondere auf einer ebenen Oberfläche des MID-Schaltungsträgers angeordnet.

Daher umfasst eine elektrische Schaltanordnung mindestens ein elektrisches Kontaktpaar, das ein Leiterplatten-Kontaktelement und ein MID-Kontaktelement umfasst, wobei die elektrische Verbindung zwischen den verschiedenen Kontaktelementen durch ein elektrisch leitendes Verbindungselement vorgesehen ist. Ein derartiges elektrisch leitendes Verbindungselement umfasst leitfähiges Klebemittel. Das elektrisch leitendes Verbindungselement hat den weiteren Zweck der mechanischen Verbindung zwischen MID-Schaltungsträger und der Leiterplatte. Als elektrisch leitendes Verbindungselement wird leitfähiges Klebemittel verwendet, das inhärent auch mechanische kraftübertragende Verbindungen vorsieht, so wird über eine derartige elektrisch leitende Verbindung auch eine Befestigung erzielt. Zur Befestigung von Leiterplatte und MID-Schaltungsträger können ferner zusätzliche rein mechanische Verbindungselemente verwendet werden, wobei jedoch vorzugsweise zwischen dem MID-Schaltungsträger und der Leiterplatte ein mechanisches Verbindungselement vorgesehen wird, das auch ein elektrisch leitendes Verbindungselement darstellt, und umgekehrt. Durch die Verwendung von Klebemittel, das leitfähig ist, wird eine derartige mechanisch-elektrische Doppelfunktion für das jeweilige Verbindungselement vorgesehen. Ferner kann der Flächeninhalt der MID-Kontaktelemente und der Verbindungsschnittstellen-Kontaktelemente derart vorgesehen werden, dass die Verbindung einer bestimmten maximalen mechanischen Belastung standhält, auch wenn zur elektrischen Verbindung kleinere Flächeninhalte ausreichend sind. In ähnlicher Weise kann auch der Flächeninhalt gemäß einer hohen Strombelastung, d.h. einem geringen Kontaktwiderstand ausgelegt werden, wobei die zur mechanischen Verbindung geringere Flächeninhalte erforderlich sind, beispielsweise auf Grund von externen mechanischen Befestigungselementen oder einer zu erwartenden geringen mechanischen Belastung.

Als mechanische Verbindungselemente, die nicht zusammen mit den elektrischen Verbindungselementen ausgeführt werden, können elastische Elemente, Klebestellen, Schweissnähte, Clips, Verstemmelemente, Verschraubungen, Nietverbindungen, Einschnappverbindungen und ähnliches verwendet werden, eine kraftschlüssige, formschlüssige oder stoffschlüssige mechanische Verbindung vorsehen. Diese mechanischen Verbindungselemente können leitend oder nicht leitend ausgebildet sein. Vorzugsweise werden Verbindungselemente, die lediglich eine mechanische Verbindung aufbauen, mit mindestens einem elastischen Element vorgesehen, wobei das elastische Element durch den MID-Schaltungsträger, oder durch die Leiterplatte vorgesehen werden kann, sowie durch Verbindungselemente, die den MID-Schaltungsträger und die Leiterplatte miteinander verbinden.

Vorzugsweise sehen die mechanischen Verbindungselemente einen konstanten Druck zwischen MID-Schaltungsträger und der Leiterplatte vor, sodass der MID-Schaltungsträger und die Leiterplatte mit einem bestimmten Druck aufeinander gepresst werden. Der Pressdruck dient unter anderem der Stabilisierung der elektrischen Verbindung.

Die durch die elektrischen Verbindungselemente hergestellte elektrische Verbindung verbindet MID-Kontaktelemente mit jeweiligen zugeordneten Verbindungsschnittstelle-Kontaktelementen. Die MID-Kontaktelemente können direkt mit Leitungselementen des MID-Schaltungsträgers verbunden sein, wobei derartige Leitungselemente die Verschaltung innerhalb des MID-Schaltungsträgers vorsehen. Derartige Leitungselemente sind beispielsweise aus einer leitenden Schicht ausgebildet, die gemäß der gewünschten Verschaltung mit einem Muster versehen wird. In gleicher Weise sind die Verbindungsschnittstelle-Kontaktelemente speziell ausgeformte Abschnitte einer leitenden Schicht, die vorzugsweise auf einer der Außenflächen der Leiterplatte vorgesehen ist. Im allgemeinen sind Verbindungsschnittstelle-Kontaktelemente vorzugsweise Oberflächen-Kontaktelemente eines elektrischen Bauteils, die entlang einer Fläche bzw. Oberfläche ausgebildet sind. Die Fläche kann gekrümmt sein oder ist vorzugsweise eben.

Üblicherweise ist eine Leiterplatte mit einer Kupferschicht beschichtet, deren Ausbildung die elektrische Verschaltung innerhalb der Leiterplatte definiert. Die Leiterplatte sowie der MID-Schaltungsträger können weitere Schichten, beispielsweise Zwischenschichten aufweisen, die nur zur Verschaltung innerhalb des MID-Schaltungsträgers und der Leiterplatte vorgesehen sind, wobei weitere elektrische Verbindungselemente den Kontakt zu den jeweiligen Kontaktelementen herstellen, beispielsweise einer Durchkontaktierung in der Leiterplatte.

Um eine homogene elektrische Verbindung vorzusehen, sind sowohl zumindest ein Leiterplattenabschnitt bzw. ein Abschnitt eines elektrischen Bauteils, das Verbindungsschnittstelle-Kontaktelement als auch die Oberfläche des MID-Schaltungsträgers komplementär zueinander ausgebildet, um ferner die gemeinsame Anordnung aller Kontaktelemente der elektrischen Schaltanordnung vorzusehen. Da sich bei Leiterplatten die Verbindungsschnittstellen-Kontaktelemente nur geringfügig (weniger als 0,1 mm) von der Leiterplatte weg erstrecken, wird vorzugsweise das MID-Kontaktelement derart ausgebildet, dass es sich von dem MID-Schaltungsträger weg erstreckt und entlang einer zur Leiterplatte bzw. zur Verbindungsschnittstelle führenden Richtung angeordnet ist. Die derart ausgeformten MID-Kontaktelemente, die sich von dem MID-Schaltungsträger weg erstrecken, schaffen somit ausreichend Abstand zwischen MID-Schaltungsträger und Leiterplatte, um unerwünschte Kontaktierungen oder kapazitive Kopplungen bzw. induktive Kopplungen zu vermeiden bzw. zu reduzieren.

Die sich nach außen (d.h. in einer vom MID-Schaltungsträger weg führenden Richtung) erstreckenden MID-Kontaktelemente werden vorzugsweise in gleicher Weise hergestellt, wie auch die dreidimensionale Form des MID-Schaltungsträgers ausgeprägt wird, beispielsweise durch plastische Verformung bei erhöhter Temperatur oder durch Prägen. Als Form der MID-Kontaktelemente wird vorzugsweise eine Halbkugel verwendet, die auch bei höheren mechanischen Belastungen stabil bleibt. Je nach gewünschten elektrischen und elastisch-mechanischen Eigenschaften kann sich das MID-Kontaktelement mit einem konstanten Querschnitt bzw. mit einer konstanten Querschnittsfläche von dem MID-Schaltungsträger weg erstrecken, oder kann sich zur Verbindungsschnittstelle hin verjüngen. Als Form eignet sich daher insbesondere eine Form, die sich nur in einer von dem MID-Schaltungsträger weg weisende Richtung erstreckt, d.h. Zylinder, Kegel, Kegelstumpf, Pyramide, Pyramidenstumpf mit jeweiligen Querschnitten, beispielsweise kreisförmig, oval, quadratisch, rechteckig, polygonal oder eine Mischform hiervon. Der Querschnitt sowie insbesondere der Grad der Verjüngung des MID-Kontaktelements hat Auswirkungen auf die mechanischen Eigenschaften, insbesondere auf die elastischen Eigenschaften des MID-Kontaktelements, insbesondere wenn der MID-Schaltungsträger und somit auch das einteilig damit ausgeführte MID-Kontaktelement aus einem Material mit elastischen Eigenschaften ist. Ebenso können Formen verwendet werden, die sich in einer von dem MID-Schaltungsträger weg weisende Richtung sowie entlang einer sich parallel zum MID-Schaltungsträger erstreckenden Rechnung erstreckt, beispielsweise Zylinder, deren Achse sich parallel zum MID-Schaltungsträger erstreckt und einen halbkreisförmigen, halbovalförmigen, quadratischen, trapezoiden oder rechteckigen Querschnitt aufweist. Vorzugsweise ist der verjüngt sich der Querschnitt des parallel zum MID-Schaltungsträger verlaufenden Zylinders in einer Richtung, die senkrecht vom MID-Schaltungsträger weg führt.
Daher wird vorzugsweise als Substrat für den MID-Schaltungsträger ein Material verwendet, das bei Einsatztemperatur nicht spröde ist und zumindest teilweise elastische Eigenschaften und geeignete plastische Eigenschaften aufweist, wobei das Material ferner zur dreidimensionalen Gestaltung vorzugsweise bei höheren Temperaturen leicht plastisch verformbar ist bzw. Fließeigenschaften erreicht.

Grundsätzlich kann das erfindungsgemäße Konzept zur Verbindung von MID-Schaltungsträgern und beliebigen, d.h. auch beliebig geformten Kontaktanordnungen von beliebigen elektrischen Bauelementen verwendet werden. Grundsätzlich müssen daher die MID-Kontaktelemente komplementär zu den jeweiligen Kontaktelementen des daran anzuschließenden elektrischen Bauteils angeordnet werden. Vorzugsweise hat jedoch die durch die MID-Kontaktelemente und die Kontaktanordnung definierte Fläche keine Hinterschneidungen, d.h. hat eine maximale Gesamtkrümmung von weniger als 180° und weist vorzugsweise eine regelmäßige bzw. elementare geometrische Form auf.

### Kurze Beschreibung der Zeichnungen

Ausführungsbeispiele der Erfindung sind in den Zeichnungen dargestellt und in der nachfolgenden Beschreibung näher erläutert.

Es zeigen
- Figur 1: eine erfindungsgemäße elektrische Schaltanordnung im Querschnitt und
- Figur 2: eine isometrische Darstellung einer weiteren erfindungsgemäßen elektrischen Schaltanordnung.

### Ausführungsformen der Erfindung

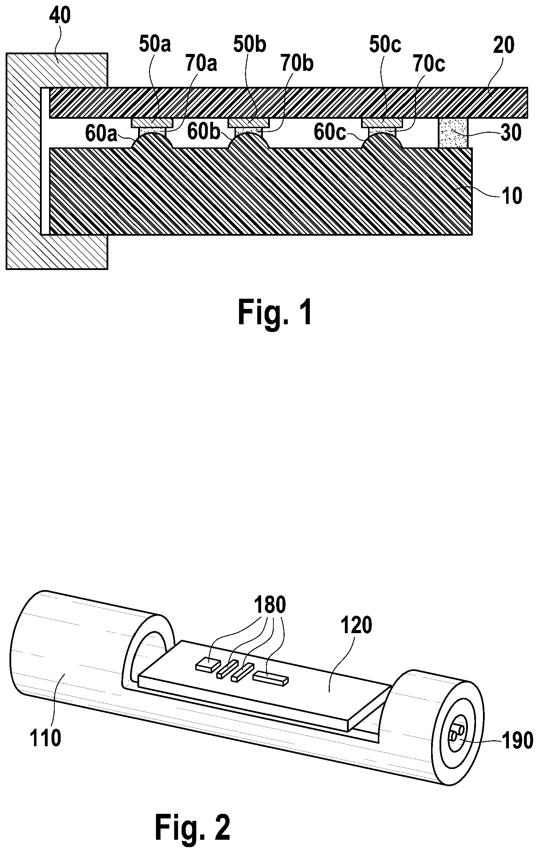

In der Figur 1 ist eine elektrische Schaltanordnung dargestellt, die eine ebene Verbindungsschnittstelle 20 und einen MID-Schaltungsträger 10 umfasst. Die Verbindungsstelle 20 ist mit dem MID-Schaltungsträger 10 über drei einzelne elektrische Kontaktpaare verbunden, wobei jedes Kontaktpaar eine einzelne elektrische Verbindung herstellt, die getrennt von den elektrischen Verbindungen der anderen elektrischen Kontaktpaare ist. In der Figur 1 ist die Verbindungsschnittstelle 10 durch einen isolierenden Träger bzw. durch ein Substrat und eine darauf angeordnete geätze Kupfer-Aussenschicht ausgebildet, die eine Leiterplatte formen. Die Kupfer-Aussenschicht bildet Kontaktflächen bzw. Pads, die vorzugsweise einteilig mit Leiterbahnen (nicht dargestellt) ausgebildet sind. Jedes elektrische Kontaktpaar umfasst ein Verbindungsschnittstellen-Kontaktelement, ein elektrisches Verbindungselement, das elektrisch leitendes Material, beispielsweise leitendes Klebemittel, umfasst, sowie MID-Kontaktelemente 60 a-c. Das elektrisches Verbindungselement, welches in Fig. 1 als leitendes Klebemittel ausgeführt ist, ist gestrichelt dargestellt. Anstatt Klebemittel kann auch Lot verwendet werden, vorzugsweise aufgetragenen Lötpaste, die mittels Reflowtechnik erhitzt wird. Die MID-Kontaktelemente 60 a-c sind auf einer ebenen Oberfläche des MID-Schaltungsträgers 10 angeordnet, die der Verbindungsschnittstelle zugewandt ist. Ferner umfasst die in Figur 1 dargestellte elektrische Schaltanordnung zusätzliche, rein mechanische Verbindungselemente 30, 40, wobei das mechanische Verbindungselement 30 eine Klebestelle zwischen der Verbindungsstelle und dem MID-Schaltungsträger darstellt. Insbesondere ist die Klebestelle 30 zwischen den Oberflächen des MID-Schaltungsträgers und der Verbindungsschnittstelle (d.h. der Leiterplatte) vorgesehen, die einander zugewandt sind. Ferner ist mit dem Bezugszeichen 40 ein alternatives mechanisches Verbindungselement dargestellt, das als Federelement bzw. als Clip ausgebildet ist. Durch die formschlüssige Gestaltung entsteht ein Presssitz, der die Verbindungsschnittstelle auf die MID-Kontaktelemente und somit zu dem MID-Schaltungsträger hinpresst. Eine ähnliche Kraft wird durch die Klebestelle 30 hervorgerufen, wobei die Klebestelle 30 eine entsprechende Zugkraft auf Verbindungsschnittstelle 20 und MID-Schaltungsträger 10 ausübt. Ferner können die Verbindungselemente 70 a-c, die als leitendes Klebemittel ausgeformt sind, gleichzeitig eine mechanische Verbindung erzeugen, die ebenfalls zur Befestigung der Verbindungsschnittstelle 20 mit dem MID-Schaltungsträger 10 dient. Somit bilden die Verbindungselemente 70 a-c gleichzeitig mechanische Verbindungselemente.

Die Verbindungsschnittstelle 20 ist als nicht leitender Träger ausgebildet, auf dem leitende Kontaktfelder 50 a-c angeordnet sind. Die Kontaktfelder 50 a-c haben korrespondierende bzw. komplementäre gegenüberliegende Entsprechungen, die durch die MID-Kontaktelemente 60a-c vorgesehen werden. Als Verbindungsschnittstelle 20 kann eine Leiterplatte oder ein Leiterplattenabschnitt verwendet werden, der sich eben erstreckt, wobei die Kontaktfelder 50 a-c durch entsprechende Ausformungen der Leiterbahnen bzw. einer leitenden Außenschicht der Leiterplatte gebildet werden.

Im Allgemeinen können die Verbindungsschnittstellen-Kontaktelemente auch beispielsweise die Stirnseiten von Kontaktpins sein, wobei die Kontaktpins an einen gemeinsamen Träger befestigt sind, beispielsweise an einem Bauteil, Modul oder ähnliches. Die Verbindungsschnittstellen-Kontaktelemente können daher von einem gemeinsamen Träger hervorstehen oder können nur unwesentlich von einem gemeinsamen Träger hervorstehen, wie es bei einer Leiterplatte der Fall ist, und können bündig mit einer Trägeroberfläche abschließen, beispielsweise im Falle einer planaren Struktur wie einem Chip.

Die Verbindungsschnittstelle 20 kann ferner weitere elektrische oder elektronische Bauelemente (in Fig. 1 nicht dargestellt) tragen. Insbesondere kann als Verbindungsschnittstelle 20 eine Leiterplatte vorgesehen sein, die zusätzlich mindestens eine Schaltung umfasst und daher entsprechende Schaltungselemente bzw. Bauelemente trägt. Die Verbindungen zwischen den Bauelementen kann durch Leiterplattenbeschichtungen bzw. -kaschierungen vorgesehen werden, mittels denen auch die Kontaktfelder 50 ausgebildet sind. Vorzugsweise sind zumindest einige der Baulemente und Verbindungen mit den Kontaktfeldern 50 verbunden.

Die Figur 2 zeigt eine erfindungsgemäße Verbundstruktur in isometrischer Darstellung. Die dargestellt Verbundstruktur umfasst eine erfindungsgemäße elektrische Schaltanordnung mit einem MID-Schaltungsträger 110 und einem Bauteil, das eine Verbindungsschnittstelle in Form einer Leiterplatte 120 umfasst, wobei die Leiterplatte ferner elektrische bzw. elektronische Bauteile 180 trägt, die als SMD-Bauteile und als Durchsteck-Bauteile ausgeführt sind. Die nicht dargestellte Unterseite der Leiterplatte 120 trägt entsprechende Kontaktfelder, die sich jeweiligen MID-Kontaktelementen gegenüberstehen. Die Leiterplatte ist vorzugsweise an der Unterseite mit dem MID-Schaltungsträger 10 verbunden, wobei der MID-Schaltungsträger eine zylindrische Grundform aufweist, der ein Halbzylinder geringerer Höhe entnommen ist, sodass ein Teil der Gesamtoberfläche des MID-Schaltungsträgers eine ebene Oberfläche ist, auf die die Leiterplatte bei 110 koplanar angeordnet werden kann.

Der MID-Schaltungsträger umfasst ferner ein Kopfende, an dem Verbindungsmittel angebracht sind, die beispielsweise als Stecker, Buchse, Lötpins oder als Steckverbinder ausgebildet sind.
Gemäß einer besonderen Ausführung der Erfindung ist mindestens ein Bauelement der Bauelemente 180 ein Drucksensor, wobei ein komplexer Abschnitt zur Datenverarbeitung auf der Leiterplatte 120 untergebracht ist, und die Anschlüsse nach außen über eine erfindungsgemäße Kontaktelementgruppe vorgesehen ist, die den Kontakt zu dem MID-Schaltungsträger herstellt, welcher wiederum als Übertragungsmedium zu einer weiteren externen Schnittstelle 190 dient. Der MID-Schaltungsträger bietet in diesem Fall weitgehenden mechanischen Schutz sowie eine stabile Halterung für die auf der Leiterplatte 120 untergebrachte Schaltung, wobei das an dem Kopfende angeordnete Verbindungsmittel 190 zu mechanischen sowie zu elektrischen Verbindungen mit externen Geräten dient.

Üblicherweise werden im Allgemeinen sowie insbesondere bei Vorrichtungen, wie sie in Figur 2 dargestellt sind, die erfindungsgemäßen Kontakte als streifenförmige Erhebungen des MID-Schaltungsträgers, die die MID-Kontaktelemente bilden, und durch Leiterplatten-Kontaktelemente realisiert, die den MID-Kontaktelementen entsprechen. Die Leiterplatten-Kontaktelemente können ebenfalls als eindimensionale Kontaktelemente ausgebildet sein, oder können flächig realisiert sein. Gemäß einer Ausführung der Erfindung sind sowohl MID-Kontaktelement als auch Leiterplatten-Kontaktelement als Streifen ausgebildet, die sich jedoch in verschiedene Richtungen erstrecken, beispielsweise in einem 90° Winkel zueinander. Durch diese Kreuzung ergeben sich exakt definierte Kontaktpunkte, sodass der Kontaktwiderstand zwischen den beiden Kontaktelementen von der Anordnung im Wesentlichen unabhängig ist.

In der Figur 2 sind die Kontaktelemente des MID-Schaltungsträgers und die Kontaktelemente der Leiterplatte jeweils miteinander verklebt. Die jeweilige Klebestelle wird erzeugt, indem entweder auf die Leiterplatten-Kontaktelemente, auf die MID-Kontaktelemente oder auf beide eine bestimmte Menge an leitendem Klebemittel aufgetragen wird, sodass sich beim Aufbringen der Leiterplatte auf den MID-Schaltungsträger das Klebemittel derart verteilt, dass eine zuverlässige elektrische (und mechanische) Verbindung zwischen den jeweiligen Kontaktelementen entsteht, und gleichzeitig vermieden wird, dass benachbarte MID-Kontaktelemente oder benachbarte Leiterplatten-Kontaktelemente durch sich verteilende Klebemittel miteinander elektrisch verbunden werden. Diese unerwünschte elektrische Kontaktierung der Kontaktelemente untereinander wird durch die gewählte Masse sowie durch den Abstand der MID-Kontaktelemente bzw. der Leiterplatten-Kontaktelemente untereinander entsprechend gewählt. Gemäß einer weiteren Ausführung der Erfindung umfasst der MID-Schaltungsträger, wie er beispielsweise in Figur 2 dargestellt ist, zwei äußere durchgängige MID-Kontaktelemente, die sich entlang der gesamten ebenen Oberfläche parallel zur Zylinderachse erstrecken und die, neben der elektrischen und mechanischen Kontaktbildung mit den jeweiligen Leiterplatten-Kontaktelementen auch einen Überlaufschutz vorsehen, der verhindert, dass beim Aufbringen der Leiterplatte auf den MID-Schaltungsträger das sich verteilende Klebemittel oder die aufgebrachte Lötpaste außerhalb der dafür vorgesehenen Oberfläche verteilt.

Der in Figur 2 dargestellte MID-Schaltungsträger umfasst einen Abschnitt, in der Figur 2 auf der linken Seite dargestellt, in dem der MID-Schaltungsträger einen runden Querschnitt aufweist und als Hohlzylinder ausgebildet ist. Durch die Ausbildung als Hohlzylinder ergeben sich elektrische, mechanische und fluidische Verbindungsmöglichkeiten durch den Hohlzylinder hindurch zu der Leiterplatte hin, wobei derartige Verbindungen beispielsweise verwendet werden können, um den auf der Leiterplatte 120 untergebrachten Sensor in Fluidverbindung, oder zumindest druckübertragend, mit externen Volumina zu verbinden. In gleicher Weise kann die Leiterplatte einen Temperatursensor tragen, der über die Fluidverbindung die Temperatur externer Volumina erfassen kann. Gemäß einer weiteren Ausführung ist der in Figur 2 dargestellte MID-Schaltungsträger entlang des Längsabschnitts, in dem der MID-Schaltungsträger als Halbzylinder ausgebildet ist, mit einem geringeren Radius vorgesehen, sodass sich auf der Höhe der Leiterplatte bzw. der dafür vorgesehenen Oberfläche ein Versatz zur Längsachse des Zylinders hin ergibt. Dieser Versatz kann verwendet werden, um Gehäuseelemente einzufügen, die die Leiterplatte schützen, wobei die Wanddicke derartiger Gehäuseelemente durch den geringeren Radius kompensiert werden kann, sodass ein derartiges Gehäuseelement nicht über die Aussenfläche der Vollzylinderabschnitte des MID-Schaltungsträgers oder nur geringfügig hinaus steht.

## Patentansprüche

1. Elektrische Schaltanordnung mit einem MID-Schaltungsträger (10) und einer Leiterplatte (20), wobei die Leiterplatte (20) auf einer Oberfläche des MID-Schaltungsträgers (10) angeordnet ist, und die elektrische Schaltanordnung ferner mindestens ein elektrisches Kontaktpaar mit mindestens einem Leiterplatten-Kontaktelement (50a - c) und mindestens einem auf der Oberfläche des MID-Schaltungsträgers (10) vorgesehenen und dem Leiterplatten-Kontaktelement (50a - c) gegenüber angeordneten MID-Kontaktelement (60a - c) umfasst, wobei mindestens eines der elektrischen Kontaktpaare ferner ein elektrisch leitendes Verbindungselement (70a - c) aufweist, das zwischen dem Leiterplatten-Kontaktelement (50a - c) und dem MID-Kontaktelement (60a - c) angeordnet ist und diese elektrisch miteinander verbindet, wobei das elektrische Verbindungselement (70 a - c) ein isotrop oder anisotrop leitfähiges Klebemittel ist, und wobei das Klebemittel (70a - 70c) auch ein mechanisches Verbindungselement zur Befestigung von Leiterplatte und MID-Schaltungsträger darstellt, und wobei die Leiterplatte mehrlagig ausgebildet ist und eine Zwischenlage umfasst, die zur Verschaltung innerhalb der Leiterplatte vorgesehen ist.

2. Elektrische Schaltanordnung nach Anspruch 1, wobei sich das Leiterplatten-Kontaktelement (50a - c) direkt auf der Leiterplatte (20) befindet und als Flächenleiter-Kontaktfeld, als Kontaktstreifen oder als punktförmiges Kontaktelement ausgebildet ist, und das MID-Kontaktelement (60a - c) in oder auf der Oberfläche des MID-Schaltungsträgers (10) ausgebildet ist, wobei sich ferner entweder MID-Kontaktelement zu dem Leiterplatten-Kontaktelement hin erstreckt, das Leiterplatten-Kontaktelement zu dem MID-Kontaktelement hin erstreckt, oder sich Leiterplatten-Kontaktelement als auch MID-Kontaktelement jeweils zueinander hin erstrecken.

3. Elektrische Schaltanordnung nach einem der vorangehenden Ansprüche, die ferner mindestens ein mechanisches kraft-, form- oder stoffschlüssiges Verbindungselement (30, 40) aufweist, das als elastisches Element, Klebestelle (30), Clip (40) oder Verstemmelement leitend oder nichtleitend ausgebildet ist.

4. Elektrische Schaltanordnung nach einem der vorangehenden Ansprüche, wobei sich die Leiterplatte (20), das Leiterplatten-Kontaktelement (50a - c) und die Oberfläche des MID-Schaltungsträgers (10) im wesentlichen koplanar zueinander erstrecken.

5. Elektrische Schaltanordnung nach einem der vorangehenden Ansprüche, wobei das MID-Kontaktelement (60a - c) die Form eines sich vom MID-Schaltungsträger weg erstreckenden Zylinders oder die Form eines zum Leiterplatten-Kontaktelement (50a - c) hin verjüngenden Kegels oder Kegelstumpfs mit kreisförmigem, ovalem, quadratischem, rechteckigem oder polygonalem Querschnitt, oder die Form einer Halbkugel (60 a-c), eines Quaders, eines Kreiszylinders einer Pyramide oder eines Pyramidenstumpfs oder die Form eines entlang der Oberfläche des MID-Schaltungsträgers verlaufenden Streifens aufweist, der eine konstante Erhebungshöhe gegenüber der Oberfläche aufweist.

## Claims

1. Electrical switching arrangement having an MID circuit carrier (10) and a printed circuit board (20), wherein the printed circuit board (20) is arranged on a surface of the MID circuit carrier (10), and the electrical switching arrangement also comprises at least one electrical contact pair having at least one printed circuit board contact element (50a-c) and at least one MID contact element (60a-c), which is provided on the surface of the MID circuit carrier (10) and arranged opposite the printed circuit board contact element (50a-c), wherein at least one of the electrical contact pairs also has an electrically conductive connecting element (70a-c), which is arranged between the printed circuit board contact element (50a-c) and the MID contact element (60a-c) and electrically connects said printed circuit board contact element and MID contact element to one another, wherein the electrical connecting element (70a-c) is an isotropically or anisotropically conductive adhesive, and wherein the adhesive (70a-70c) also constitutes a mechanical connecting element for fastening printed circuit board and MID circuit carrier, and wherein the printed circuit board is of multi-layered design and comprises an intermediate layer, which is provided for interconnection within the printed circuit board.

2. Electrical switching arrangement according to Claim 1, wherein the printed circuit board contact element (50a-c) is located directly on the printed circuit board (20) and is designed as a planar conductor contact field, as a contact strip or as a punctiform contact element, and the MID contact element (60a-c) is formed in or on the surface of the MID circuit carrier (10), wherein furthermore either the MID contact element extents towards the printed circuit board contact element, the printed circuit board contact element extends towards the MID contact element or the printed circuit board contact element and the MID contact element respectively extend towards one another.

3. Electrical switching arrangement according to either of the preceding claims, which also has at least one mechanical force-fitting, form-fitting or materially bonded connecting element (30, 40), which is designed in a conductive or non-conductive manner as an elastic element, an adhesive location (30), a clip (40) or a caulking element.

4. Electrical switching arrangement according to one of the preceding claims, wherein the printed circuit board (20), the printed circuit board contact element (50a-c) and the surface of the MID circuit carrier (10) extend towards one another in a substantially coplanar manner.

5. Electrical switching arrangement according to one of the preceding claims, wherein the MID contact element (60a-c) has the shape of a cylinder extending away from the MID circuit carrier or the shape of a cone or truncated cone having a circular, oval, cuboidal, rectangular or polygonal cross section and tapering towards the printed circuit board contact element (50a-c), or the shape of a hemisphere (60a-c), a cuboid, a circular cylinder, a pyramid or a truncated pyramid, or the shape of a strip running along the surface of the MID circuit carrier, which has a constant elevation with respect to the surface.

## Revendications

1. Dispositif de commutation électrique comportant un support de circuit MID (10) et une carte de circuit imprimé (20), dans lequel la carte de circuit imprimé (20) est disposée sur une surface du support de circuit MID (10), et le dispositif de commutation électrique comprend en outre au moins une paire de contacts électriques ayant au moins un élément de contact de carte de circuit imprimé (50a - c) et au moins un élément de contact MID (60a - c) prévu sur la surface du support de circuit MID (10)et disposé en face de l'élément de contact de carte de circuit imprimé (50a - c), dans lequel au moins l'une des paires de contacts électriques comporte en outre un élément de liaison électriquement conducteur (70a - c) disposé entre l'élément de contact de carte de circuit imprimé (50a-c) et l'élément de contact MID (60a - c) et les reliant l'un à l'autre électriquement, dans lequel l'élément de liaison électrique (70a - c) est un adhésif isotrope ou anisotrope conducteur, et dans lequel l'adhésif (70a 70c) constitue également un élément de liaison mécanique permettant de fixer la carte de circuit imprimé et le support de circuit MID, et dans lequel la carte de circuit imprimé est réalisée sous forme multicouche et comprend une couche intermédiaire prévue pour les interconnexions à l'intérieur de la carte de circuit imprimé.

2. Dispositif de commutation électrique selon la revendication 1, dans lequel l'élément de contact de carte de circuit imprimé (50a - c) est situé directement sur la carte de circuit imprimé (20) et est réalisé sous la forme d'un champ de contact conducteur en surface, d'une bande de contact ou d'un élément de contact ponctuel, et l'élément de contact MID (60a - c) est réalisé dans ou sur la surface du support de circuit MID (10), dans lequel soit l'élément de contact MID s'étend en outre vers l'élément de contact de carte de circuit imprimé, soit l'élément de contact de carte de circuit imprimé s'étend vers l'élément de contact MID, soit l'élément de contact de carte de circuit imprimé ainsi que l'élément de contact MID s'étendent respectivement l'un vers l'autre.

3. Dispositif de commutation électrique selon l'une des revendications précédentes, comportant en outre au moins un élément de liaison mécanique (30, 40) assemblé par complémentarité de force, de forme ou de matériau et réalisé sous la forme d'un élément élastique, d'un point d'adhésif (30), d'une pince (40) ou d'un élément de calfatage conducteur ou non conducteur.

4. Dispositif de commutation électrique selon l'une des revendications précédentes, dans lequel la carte de circuit imprimé (20), l'élément de contact de carte de circuit imprimé (50a - c) et la surface du support de circuit MID (10) s'étendent de manière sensiblement coplanaire les uns par rapport aux autres.

5. Dispositif de commutation électrique selon l'une des revendications précédentes, dans lequel l'élément de contact MID (60a - c) présente la forme d'un cylindre partant du support de circuit MID ou présente une forme conique ou tronconique se rétrécissant vers l'élément de contact de la carte de circuit imprimé (50a - c) avec une section circulaire, ovale, carrée, rectangulaire ou polygonale, ou présente la forme d'un hémisphère (60a - c), d'un parallélépipède, d'un cylindre circulaire, d'une pyramide ou d'une pyramide tronquée ou présente la forme d'une bande s'étendant le long de la surface du support de circuit MID qui présente une hauteur constante par rapport à la surface.
